# EUROPEAN PATENT APPLICATION

(11) **EP 0 613 191 A2**
(43) Date of publication of application: **31.08.1994**
(21) Application number: 94102644.5
(22) Date of filing: 22.02.1994
(51) Int. Cl.: H01L 29/812, H01L 29/10, H01L 29/784

(54) **Channel structure for field effect transistor**

(30) Priority: 26.02.1993 JP 38287/93
(71) Applicant: SUMITOMO ELECTRIC INDUSTRIES, LIMITED, Osaka 541 (JP)
(72) Inventor: Matsuzaki, Ken-ichiro, c/o Yokohama Works of, Yokohama-shi, Kanagawa (JP); Nakajima, Shigeru, c/o Yokohama Works of, Yokohama-shi, Kanagawa (JP); Kuwata, Nobuhiro, c/o Yokohama Works of, Yokohama-shi, Kanagawa (JP); Otobe, Kenji, c/o Yokohama Works of, Yokohama-shi, Kanagawa (JP); Shiga, Nobuo, c/o Yokohama Works of, Yokohama-shi, Kanagawa (JP)
(74) Representative: Kahler, Kurt, Dipl.-Ing.

(57) **Abstract**

This invention provides an FET having a high mobility of channel electrons and a high saturation electron rate. For this purpose, in this invention, an undoped buffer layer (12), a heavily doped channel layer (13), and an undoped capping layer (14) are formed on a semi-insulating GaAs semiconductor substrate (11). An n⁺-type drain region (15) and an n⁺-type source region (16) are formed by selective ion implantation. Subsequently, a gate electrode (17), a drain electrode (18), and a source electrode (19) are formed. Since the channel layer (13) is formed by gradually increasing the supply quantity of SiH₄ gas, an impurity concentration becomes low when the depth from the substrate surface increases. Therefore, since the impurity concentration becomes low at the bottom of the channel layer (13) along which electrons tend to move, an influence of impurity scattering on carriers can be reduced.

## Description

### BACKGROUND OF THE INVENTION

### Field of the Invention

The present invention relates to the structure of a field effect transistor (FET) which can realize an ultra high-speed operation.

### Related Background Art

Conventionally, as an FET which can realize an ultra high-speed operation, an FET in which an active layer for forming a current channel adopts a so-called pulse-doped structure is known. In the FET with the pulse-doped structure, the impurity profile of the active layer reveals an undoped state from the substrate surface to a predetermined depth. However, the impurity concentration changes in a pulse-like pattern or stepwise to a high concentration at the predetermined depth from the substrate surface, and the impurity concentration is held at the high constant value to a given depth. At a deeper substrate position, the impurity profile returns to an undoped state. Such an FET with the pulse-doped structure is described in, e.g., U.S. Patent No. 4,163,984 or on p. 759 of the following reference:
1986 IEEE IEDM "A 760 mS/mm N⁺SELF-ALIGNED ENHANCEMENT MODE DOPED-CHANNEL MIS-LIKE FET (DMT)" However, in an operation of the conventional FET with the pulse-doped structure, the following problem occurs.

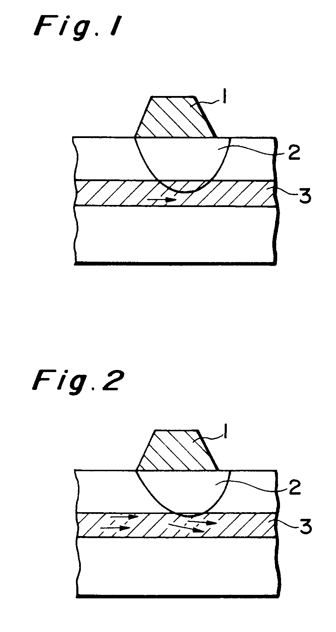

As shown in Fig. 1, a channel depletion layer 2 generated below a gate electrode 1 extends to the active layer 3 (described above) to which an impurity is pulse-doped with an increase in bias to the gate electrode 1. In the vicinity of a pinch-off region where a current channel formed in the active layer 3 is almost closed, most of electrons as carriers are moved by the channel depletion layer 2 to travel along the bottom of the active layer, as indicated by an arrow in Fig. 1. Even in a state (Fig. 2) wherein a gate bias is weakened, and the channel depletion layer 2 extending to a substrate deep portion is retreated to open the channel, when an electric field applied between the drain and source is high, carriers acquire high energy and tend to move along the bottom of the active layer 3, as indicated by arrows in Fig. 2.

Accordingly, in any case, carriers move along the bottom of the active layer 3 where the impurity is doped at a high concentration. For this reason, electrons are influenced by impurity scattering, and their mobility and saturation rate are lowered. As a result, the high-frequency operation characteristics of an element cannot be improved. A transconductance gₘ of the FET which represents the rate of change in drain current with respect to a change in gate voltage cannot hold a constant value over a given range with respect to a change in gate voltage.

### SUMMARY OF THE INVENTION

The present invention has been made to solve the above-mentioned problems, and has as its object to provide an FET using a thin-film semiconductor layer having a high impurity concentration as a channel layer, wherein the channel layer is formed such that the impurity concentration becomes low from a substrate surface to a substrate deep portion.

An impurity profile of the channel layer has a maximum value of the impurity concentration plotted on the left side with respect to a vertical line passing through a center of gravity of a figure drawn by a profile line, and the profile line inclines downward to the right with respect to the vertical line in a graph having an abscissa representing a depth from the substrate surface which increases with an increase in distance from an origin and an ordinate representing the impurity concentration which increases with an increase in distance from the origin.

An impurity profile line inclines downward to the right with respect to a vertical line bisecting a line segment having two intersections obtained by intersecting the impurity profile line and an impurity concentration line representing 50% of a maximum value of the impurity concentration in the graph.

According to the present invention, since the impurity concentration becomes low at the bottom of the channel layer along which carriers tend to move, an influence of impurity scattering on carriers can be reduced. Therefore, the mobility of channel electrons increases, and the electron saturation rate also increases, thereby improving the high-frequency characteristics of an element. In addition, a transconductance gₘ of the FET is held to be a constant value over a given range with respect to a change in gate voltage.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art form this detailed description.

### BRIEF DESCRIPTION OF THE DRAWINGS

Fig. 1 is a sectional view of an FET showing a state in which electrons as carriers are influenced by a channel depletion layer in the vicinity of a pinch-off region;
Fig. 2 is a sectional view of the FET showing a state in which electrons as carriers are influenced by the channel depletion layer when a channel is opened from almost the pinch-off state;
Fig. 3 is a sectional view showing the structure of an FET according to an embodiment of the present invention;
Fig. 4 is a graph showing the impurity profile below the gate electrode of the FET according to the embodiment;
Fig. 5 is a graph showing the first modification of the impurity profile below the gate electrode of the FET according to the embodiment;
Fig. 6 is a graph showing the second modification of the impurity profile below the gate electrode of the FET according to the embodiment;
Fig. 7 is a graph showing the third modification of the impurity profile below the gate electrode of the FET according to the embodiment;
Fig. 8 is a graph showing the fourth modification of the impurity profile below the gate electrode of the FET according to the embodiment;
Fig. 9 is a graph showing the fifth modification of the impurity profile below the gate electrode of the FET according to the embodiment;
Fig. 10 is a graph showing the sixth modification of the impurity profile below the gate electrode of the FET according to the embodiment; and
Fig. 11 is a graph showing the seventh modification of the impurity profile below the gate electrode of the FET according to the embodiment.

### DETAILED DESCRIPTION OF THE PREFERRED EMBODIMENT

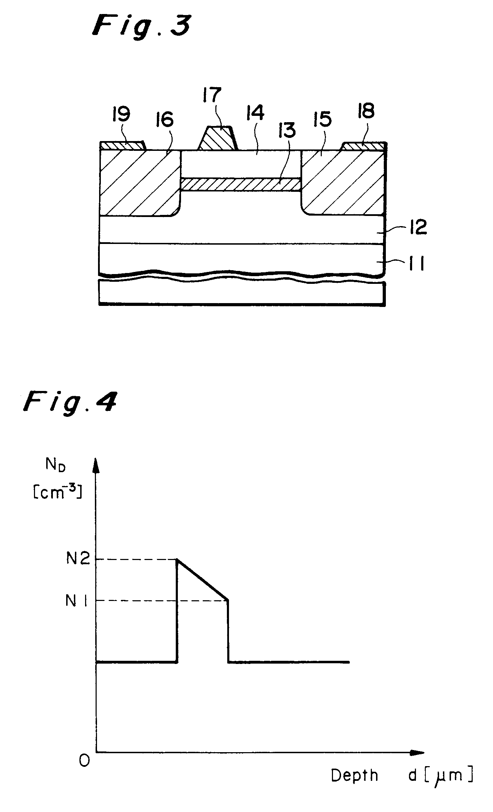

Fig. 3 is a sectional view showing the structure of an FET according to an embodiment of the present invention, and the FET is manufactured in the following manner.

An undoped GaAs buffer layer 12 is epitaxially grown on a semi-insulating GaAs semiconductor substrate 11 by an epitaxy technique such as an OMVPE (Organic Metal Vapor Phase Epitaxy) method, or the like. Upon formation of the buffer layer 12, the background conductivity of the buffer layer 12 is set to be p⁻ type by controlling the supply ratio of respective materials of Ga as a Group-III element and As as a Group-V element. In the embodiment, the impurity concentration of the buffer layer 12 is set to be as very low as 5 × 10¹⁵ [cm⁻³] or less, but it need only fall within a range of 5 × 10¹⁶ [cm⁻³] or less. Subsequently, Si-doped GaAs is epitaxially grown on the buffer layer 12 to form a channel layer 13 having a thickness of 50 to 500 Å. When the channel layer 13 is epitaxially grown, an n-type Si impurity is doped in the channel layer 13 by mixing SiH₄ gas with the supply materials. In addition, since the mixing ratio of SiH₄ gas and the supply quantity of the SiH₄ gas are gradually increased, the concentration of an Si impurity contained in the channel layer 13 gradually increases from the substrate deep portion to the substrate surface. After the channel layer 13 is formed, undoped GaAs is epitaxially grown on the channel layer 13 to form a capping layer 14 having an n⁻ background conductivity type. The thickness of the capping layer 14 is formed to be 300 to 800 Å, and the impurity concentration of the capping layer 14 is set to be very low as in the buffer layer 12.

A source/drain region pattern is formed on the substrate surface using a lithographic technique, and high-concentration Si ions are selectively implanted using this pattern as a mask. Upon the selective ion implantation, an n⁺-type drain region 15 and an n⁺-type source region 16 are formed. Thereafter, a gate electrode 17 which Schottky-contacts the capping layer 14 is formed using a deposition technique, lithographic technique, etching technique, and the like. The gate electrode 17 is formed at a position separated away from a drain electrode 18 (to be described later). Finally, the drain electrode 18 and a source electrode 19, which respectively ohmic-contact the drain region 15 and the source region 16, are formed using the same deposition technique, lithographic technique, and the like. Upon formation of these electrodes, a Schottky contact type FET (MESFET) having the structure shown in Fig. 3 is completed.

The impurity profile below the gate electrode 17 of this embodiment is shown in the graph in Fig. 4. The abscissa of the graph in Fig. 4 represents a depth d [µm] from the substrate surface, and the ordinate represents a concentration N_{D} [cm⁻³] of an n-type impurity, i.e., Si. A pulse-pattern portion in which the impurity concentration is high represents a profile corresponding to the channel layer 13. Upon formation of the channel layer 13, since a flow rate of SiH₄ gas is gradually increased as described above, an impurity concentration N1 of the deepest portion of the substrate in the channel layer 13 is as low as 1 × 10¹⁷ [cm⁻³], and an impurity concentration N2 closest to the substrate surface side is as high as 5 × 10¹⁸ [cm⁻³].

Therefore, in the FET of this embodiment, the Si impurity concentration of the channel layer 13 becomes low when the depth from the substrate surface increases as described above, so that the impurity concentration is low at the bottom of the channel layer 13 along which carriers tend to move. For this reason, the influence of impurity scattering on carriers upon moving in the channel can be reduced. More specifically, a channel depletion layer generated below the gate electrode 17 extends to an active layer 3, and most of channel electrons move along the bottom of the channel layer 13 in the vicinity of a pinch-off region where a current channel is almost closed. Since the impurity concentration at the bottom of the channel layer 13 is set low as described above, the influence of impurity scattering on channel electrons is minimized. Furthermore, in a state wherein the gate bias is weakened to open the channel, channel electrons acquire high energy by a high electric field between the drain and source, and move along the bottom of the channel layer 13 by an electric field applied from the gate electrode 17. Since the impurity concentration at this bottom is low, the influence of impurity scattering on channel electrons is minimized. In any case, channel electrons move along the bottom of the channel layer 13 having a low concentration, and the channel electrons are therefore almost free from the influence of impurity scattering. Therefore, the mobility of channel electrons increases, and the electron saturation rate also increases. As a result, a transconductance gm is increased, and a cutoff frequency fₜ of the FET becomes high, thereby improving the high-frequency operation characteristics of an element. In addition, the transconductance gm of the FET is held to be a constant value over a given range with respect to a change in gate voltage, and a change in transconductance gm with respect to a change in gate voltage exhibits flat characteristics.

Note that, in the description of the embodiment, the channel layer 13 is formed by the OMVPE method and the impurity profile of the channel layer 13 has a gradient. However, the channel layer 13 having such an impurity profile may be formed by the MBE (Molecular Beam Epitaxy) method. When this MBE method is used, an Si molecular beam intensity is increased as the channel layer is epitaxially grown, thereby realizing the same impurity profile as that of the above embodiment.

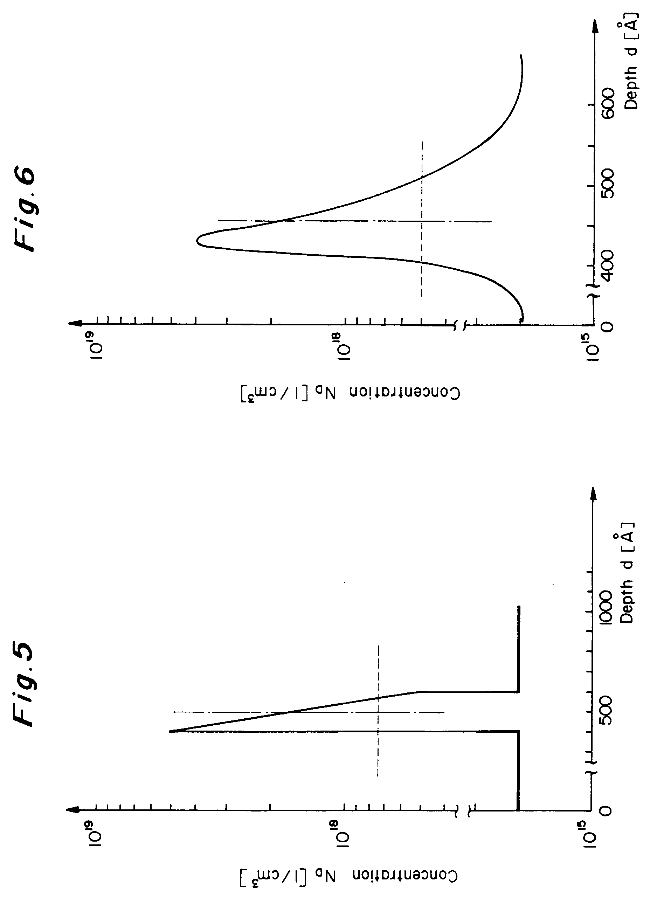

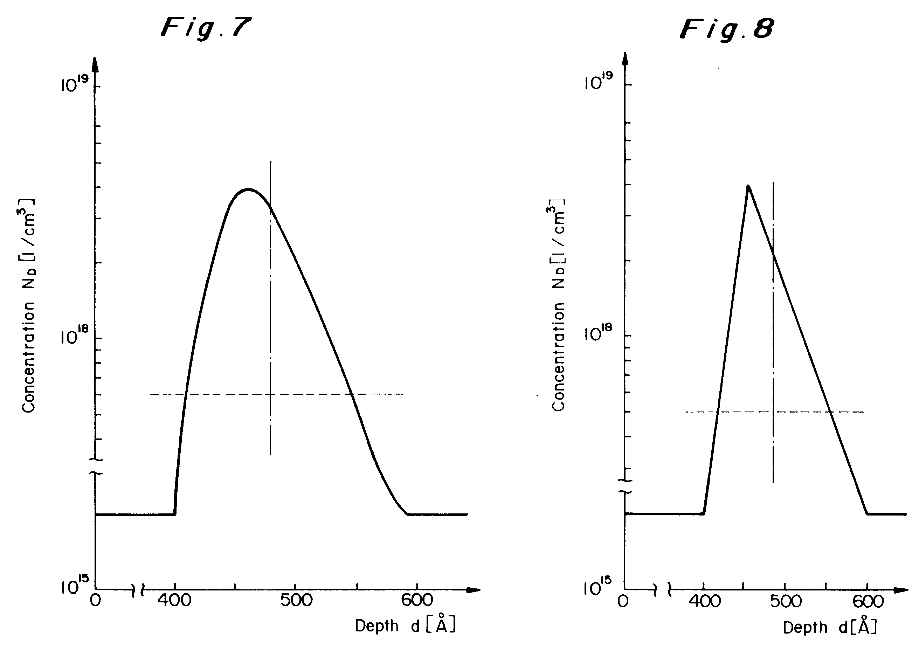

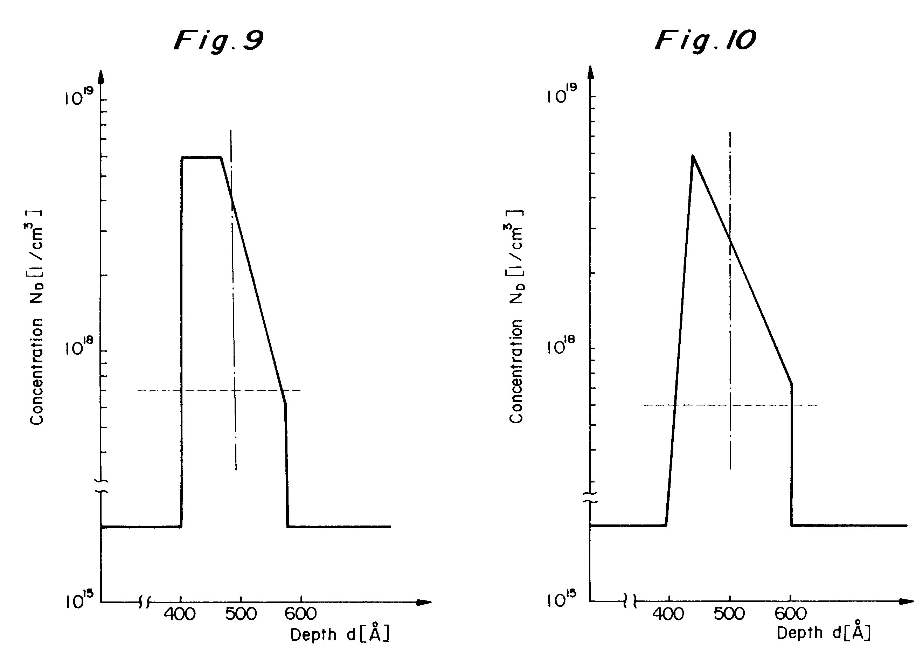

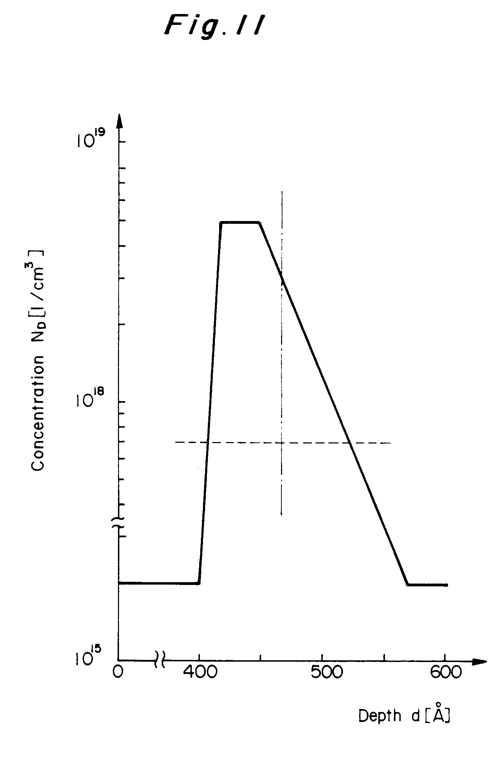

Furthermore, in the above embodiment, the FET in which the channel layer 13 has the impurity profile shown in Fig. 4 has been described. However, the present invention is not limited to this. For example, the impurity profile of the channel layer 13 may be one of profiles shown in Figs. 5 to 11. In each graph, the abscissa represents a depth d[Å] from the substrate surface, and the ordinate represents an n-type impurity concentration N_{D} [cm⁻³], as in Fig. 4. As shown in the drawings, each impurity profile as shown in each graph is formed such that the impurity concentration becomes low from the substrate surface to the substrate deep portion.

In each graph, a point at which a horizontal line indicated by a dotted line crosses a vertical line indicated by an alternate long and short dashed line corresponds to a center of gravity in a figure drawn by each profile line. In each impurity profile, when viewed from each vertical line passing through this center of gravity, the maximum value of the impurity concentration is plotted on the left side. With respect to each vertical line, each profile line inclines downward to the right. Furthermore, each impurity profile line inclines downward to the right with respect to a vertical line (not shown) bisecting a line segment having two intersections obtained by intersecting the impurity profile line and an impurity concentration line (not shown) representing 50% of a maximum value of the impurity concentration.

Even if the channel layer 13 is formed by one of the impurity profiles shown in Figs. 5 to 11, the same effect as in the above embodiment can be obtained. That is, the mobility of electrons and the electron saturation rate increase, and the high-frequency characteristics are also improved.

The maximum value of the impurity concentration of the channel layer 13 is 4 x 10¹⁸ [cm⁻³] in these graphes, but the present invention is not limited to this, and may be a range within 1 x 10¹⁸ to 8 x 10¹⁸ [cm⁻³].

In the FET of the above embodiment, the gate electrode 17 is formed at a position separated away from the drain electrode 18 to improve the breakdown voltage characteristics between the gate and drain. However, the present invention is not limited to this. The present invention can also be applied to an FET with a structure in which the gate electrode is formed at the center between the drain and source, an FET with a structure in which the gate electrode is formed in a recess, and the like, and the same effect as in the above embodiment can be obtained with these FETs.

In the description of the above embodiment, the semiconductor substrate 11 consists of GaAs. However, the present invention is not limited to this. For example, a semiconductor substrate consisting of, e.g., InP, InGaAs, or the like may be used. Si is used for an n-type impurity. However, Se, S, or the like may be used. When FETs are formed using these materials, the same effect as in the above embodiment can be obtained.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

## Claims

1. A field effect transistor using a thin-film semiconductor layer having a high impurity concentration as a channel layer (13),
wherein said channel layer (13) is formed such that the impurity concentration becomes low from a substrate surface to a substrate deep portion.

2. A field effect transistor according to claim 1, wherein an impurity profile of said channel layer (13) has a maximum value of the impurity concentration plotted on a left side with respect to a vertical line passing through a center of gravity of a figure drawn by a profile line, and the profile line inclines downward to the right with respect to the vertical line in a graph having an abscissa representing a depth from said substrate surface which increases with an increase in distance from an origin and an ordinate representing the impurity concentration which increases with an increase in distance from the origin.

3. A field effect transistor according to claim 1, wherein an impurity profile line inclines downward to the right with respect to a vertical line bisecting a line segment having two intersections obtained by intersecting the impurity profile line and an impurity concentration line representing 50% of a maximum value of the impurity concentration in a graph having an abscissa representing a depth from said substrate surface which increases with an increase in distance from an origin and an ordinate representing the impurity concentration which increases with an increase in distance from the origin.

4. A field effect transistor according to any of claims 1 to 3,
wherein said field effect transistor comprises a semiconductor substrate (11), an undoped buffer layer (12) formed on said semiconductor substrate (11), said channel layer (13) formed such that an impurity concentration becomes low from the substrate surface to the substrate deep portion, a capping layer (14) formed on said channel layer (13), a gate electrode (17) formed to Schottky-contact said capping layer (14), source and drain regions (16, 15) formed by doping an impurity at a high concentration on two sides of said gate electrode (17) to contact said channel layer (13), and source and drain electrodes (19, 18) formed to ohmic-contact said source and drain regions (16, 15), respectively.

5. A field effect transistor according to claim 4, wherein said channel layer (13) is formed to have a high impurity concentration of 5 x 10¹⁸ [cm⁻³] at a position closest to the substrate surface side, to become a lower impurity concentration toward a substrate deep portion and to have an impurity concentration of 1 x 10¹⁷ [cm⁻³] at a deepest portion of the substrate (11); and
said buffer layer (12) and said capping layer (14) are formed to have low impurity concentrations of not more than 5 x 10¹⁶ [cm⁻³].

6. A field effect transistor according to claim 4, wherein a maximum value of the impurity concentration of said channel layer (13) is formed to have a high impurity concentration of 1 x 10¹⁸ to 8 x 10¹⁸ [cm⁻³], and said buffer layer (12) and said capping layer (14) are formed to have low impurity concentrations of not more than 5 x 10¹⁶ [cm⁻³].

7. A field effect transistor according to any of claims 4 to 6,
wherein said channel layer (13) is formed to have a thickness of 5 to 50 nm (50 to 500 Å), and said capping layer (14) is formed to have a thickness of 30 to 80 nm (300 to 800 Å).

8. A field effect transistor according to any of claims 4 to 7,
wherein said buffer layer (12), said channel layer (13), and said capping layer (14) are formed by an epitaxy method.

9. A field effect transistor according to any of claims 4 to 8,
wherein said semiconductor substrate (11) consists of a compound semiconductor material selected from the group consisting of GaAs, InP, and InGaAs.

10. A field effect transistor according to any of claims 4 to 9,
wherein said channel layer (13) is formed to contain an n-type impurity selected from the group consisting of Si, Se, and S.

11. A field effect transistor according to any of claims 4 to 10,
wherein an interval between said gate electrode (17) and said drain electrode (18) is larger than an interval between said gate and source electrodes (17, 19).
